# EUROPEAN PATENT APPLICATION

(11) **EP 4 480 771 A1**
(43) Date of publication of application: **25.12.2024**
(21) Application number: 23181216.5
(22) Date of filing: 23.06.2023
(51) Int. Cl.: B60T 8/36, F16K 31/06, G01R 31/72, H01F 7/18

(54) **A METHOD OF ESTIMATING A FUNCTIONING OF A SOLENOID VALVE FOR AN OPEN-LOOP PNEUMATIC BRAKE ARRANGEMENT FOR A VEHICLE, IN PARTICULAR UTILITY VEHICLE, COMPUTER PROGRAM, SOLENOID VALVE, PNEUMATIC BRAKE ARRANGEMENT, AND VEHICLE**

(71) Applicant: ZF CV Systems Europe BV, 1170 Brüssel (BE)
(72) Inventor: BIALON, Rafal, 55-200 Olawa (PL)
(74) Representative: Ohlendorf, Henrike

(57) **Abstract**

A method (100) of estimating a functioning of a solenoid valve (250) for an open-loop pneumatic brake arrangement (210) for a vehicle (200a), in particular utility vehicle (200b), wherein the valve (250) comprises an armature (255) being adapted to be moved by an application of an electromagnetic field (EMF) to change a state of the valve (250) by moving the armature (255) between two end positions (P1, P2), wherein the method (100) comprises the steps of: cyclically adapting (110) an operation voltage (U) for applying the electromagnetic field (EMF); measuring (120), during adapting (110) the operation voltage (U), an electric current (I), depending on an inductivity (L) of the valve (250), on the operating voltage (U) and/or on time (t); and estimating (130), based on the electric current (I), the functioning of the valve (250) indicating a proper arrangement of the armature (255) in one of the two end positions (P1, P2).

## Description

The present disclosure relates to a method of estimating a functioning of a solenoid valve for an open-loop pneumatic brake arrangement for a vehicle, in particular utility vehicle, wherein the valve comprises an armature being adapted to be moved by an application of an electromagnetic field to change a state of the valve by moving the armature between two end positions. The disclosure further relates to a computer program, to a solenoid valve for a vehicle, in particular utility vehicle, wherein the valve comprises an armature being adapted to be moved by an application of an electromagnetic field to change a state of the valve, by moving the armature between two end positions, and an electronic control unit, to a pneumatic brake arrangement, and to a vehicle, in particular utility vehicle.

In such a solenoid valve, the armature is biased by a spring thereby defining a basic position or basic state, which can be a closed or an open state of the valve. For switching the valve into its other position or state, an electromagnetic coil is energized by an electric current thereby creating a magnetic flux flowing through a static core and/or static yoke and the displaceable armature, which armature in general is pulled by the magnetic force caused by an electromagnetic field against the spring bias thereby closing an air gap between the armature and the core. The basic positions and the other position may be referred to as first end position and second end position, or vice versa.

The solenoid valve may be in particular a 3/2-valve or a 2/2-valve. It is suitable for an application, in particular, in a pneumatic system of a commercial vehicle. For example, the valve may be used in an anti-blocking system (ABS) and/or in an electropneumatic braking system (EBS). As such, the proper functioning of the solenoid valve may be of importance.

EP 3 633 252 A1 discloses a solenoid fluid valve, in particular for pneumatic applications, wherein said fluid valve comprises: an inner valve core extending along an axial direction, a movable part displaceable between a basic position and an activated position, for closing and opening at least one valve seat, an outer yoke, a spring for biasing said movable part into its basic position, an electromagnetic coil to be energized for creating a magnetic circuit flowing through said inner valve core, said outer yoke and said movable part, for switching said movable part into said activated position, wherein said inner valve core, said movable part and said outer yoke are made at least partially of a magnetic material, wherein said movable part is realized as a valve plate extending in radial direction beyond an end part of the inner valve core and comprising at least one sealing face for contacting at least one valve seat.

EP 3 257 060 A1 discloses a solenoid valve with an electromagnet, wherein the electromagnet has a movably arranged solenoid armature. In addition, the solenoid valve has at least two energization states of the electromagnet which are different from one another, as well as at least one electric switching means which is configured to switch the electromagnet over from one energization state into another energization state. In this context, the various energization states of the electromagnet differ in respect of different current strengths of the current flowing through the electromagnet. The at least one electric switching means switches the energization state of the electromagnet automatically as a function of a magnetic field generated by the electromagnet or as a function of a position of the solenoid armature or a position of a valve piston of a valve controlled by the solenoid valve.

According to the prior art, a functional safety test may be based on electric pulses which allow only a possibility to detect an end stage failure, i.e., a failure in one of the end positions. Such an end stage failure may be caused by a shortcut to ground and/or by a coil breakdown.

Such a valve may be applied is a so-called open-loop system. Such an open-loop system may not comprise a pressure sensor in a pressure chamber to check the pressure in the pressure chamber. However, the pressure in the pressure chamber may be indicative of a proper functioning of the valve. Furthermore, a control of pressurized air is sensitive to tolerances of the functioning of the solenoid valve.

In the open-loop system, there may be no feedback from the pneumatic brake system, if the solenoid is activated and brake pressure is modulated. This may lead even to a safety critical event, due to the fact that no hold function on a wheel is possible or blockage of the wheel may occur due to a lack of a possibility to exhaust the pressurized air from the pressure chamber of the breaks of the vehicle. In case of a disfunction, this may lead in an open-loop braking system, to an uneven distribution of the brake pressure which may lead to unexpected behavior of the vehicle, such as a potential brake pull or even a damage of the brake, if a solenoid valve gets blocked during an active braking event.

It is known that such a valve may be used in a closed-loop system. Therein, an electronic control unit (ECU) may receive a feedback from the valve relating to its functioning and/or a pressure being provided by the valve. The feedback allows an possibility to control the functioning of the solenoid valve. However, the closed-loop system requires a pressure sensor as an additional component. Furthermore, the functioning of the valve is assessed by the result of an actuation of the valve, but not by the actuation of the valve itself.

In the light of the prior art, the object of the present disclosure is to provide a contribution to the prior art, and to provide an improved estimation of a functioning of a solenoid valve. In particular, it is an object of the disclosure to provide such an estimation for an open-loop system.

The object is solved by the features of the independent claim. The dependent claims have further embodiments of the disclosure as their subject matter.

According to an aspect of the present disclosure, a method of estimating a functioning of a solenoid valve for an open-loop pneumatic brake arrangement for a vehicle, in particular utility vehicle, is provided. Therein, the valve comprises an armature being adapted to be moved by an application of an electromagnetic field to change a state of the valve by moving the armature between two end positions, wherein the method comprises the steps of: cyclically adapting an operation voltage for applying the electromagnetic field; measuring, during adapting the operation voltage, an electric current, depending on an inductivity of the valve, on the operating voltage and/or on time; and estimating, based on the electric current, the functioning of the valve indicating a proper arrangement of the armature in one of the two end positions.

The method may be applicable to an open-loop system. However, the method may also be applied to a closed-loop system as an alternative approach to estimate the functioning of the valve.

The functioning may in particular relate to the ability of the valve to achieve a proper arrangement of the armature, in particular at and/or between the end positions. Estimating the functioning of the valve may refer to detecting, estimating and/or determining the position of the armature.

By cyclically adapting the operation voltage, i.e., changing the operating voltage in a time-dependent manner from an initial value to other values and back to the initial value, the electromagnetic field is applied cyclically. Thus, an electromagnetic force is cyclically exerted on the armature to cyclically move the armature, i.e., to change the position of the armature between the end positions, i.e., between a first end position and a second end position. The operation voltage is cyclically adapted, i.e., in a time-dependent manner. The disclosure has realized that the position of the armature affects the electric current, i.e., an electric current change that may result from the positioning and/or movement of the armature. Therein, by moving the armature, the inductivity may change which changes to electric current in response to the operation voltage. The measured electric current may thus evolve in dependence on the position of the armature. The electric current may thus be related to the voltage, to the inductivity of the valve and/or, by the time-dependence of the voltage, to time.

Based on the response of the valve, which may be indicated by the measured electric current, the functioning may be estimated by the electric current as a quantity that relates to the functioning of the valve itself, namely to the positioning of the armature. Therein, it is realized that the solenoid valve causes a characteristic dependence between the electric current and the inductivity of the valve, the operating voltage and/or time. The characteristic dependence may be compared with the measured dependence to estimate the functioning of the valve.

The method provides a closed-loop-type feedback to an electronic control unit relating to the activation and deactivation of the solenoid valve without the use of an additional pressure sensor. Due to the cyclic adaption of the voltage and the simultaneous monitoring of the electric current, the movement and/or position of the armature may be assessed. This enables assessing the positioning of the armature between the end positions. The method enables to detect, if the solenoid was activated and pneumatic control was realized by a response to the electromagnetic field and/or a change in the inductivity without the need of using a pressure sensor. Further, the method enables to detect, if the solenoid was switched off and pneumatic control was realized by a response to the electromagnetic field and/or a change in the inductivity without the need of using a pressure sensor. The method further enables a possibility to compensate for tolerances of the solenoid valve, due to a feedback about the actual pull-in current value of the solenoid, i.e., the electric current at which the armature begins to move. A reduction of a tolerance chain of the of the pressure modulators may be achieved, due to the feedback about the pull-in current as a main functional parameter with tolerance.

Optionally, adapting the operation voltage comprises, dependent on time, increasing and decreasing the operation voltage. Increasing the operation voltage may cause a motion of the armature against a biasing spring to move the armature from the first end position to the second end position. Decreasing the operation voltage may cause a motion of the armature from the second end position to the first end position. The increasing and decreasing operation voltage may thus lead to a cycle and/or loop which may cause a cyclic force on the armature and may further lead to a characteristic dependence of the electric current. Depending on the functioning of the valve, the characteristic dependence of the electric current and/or a deviation therefrom may be observed and evaluated for estimating the functioning.

Optionally, estimating the functioning of the valve comprises comparing the electric current with a reference current. Therein, the reference current may be indicative of a proper functioning of the valve. The reference current may relate to a specific position of the armature between and including the first end position and the second end position. A plurality of reference currents may relate to and/or constitute a characteristic dependence of the electric current on operating voltage, inductivity and/or time.

Optionally, the reference current comprises a non-monotonic time dependence and/or voltage dependence. Therein, it is realized that the positioning of the armature relative to the magnetic core of the valve leads to a non-monotonic dependence of the electric current on time and/or voltage. Thus, the reference current may relate to a proper functioning comprises the non-monotonic time dependence and/or voltage dependence. The non-monotonic dependence may mean that the reference current alternatingly increases and decreases, or vice versa, depending on time and/or voltage.

Optionally, the reference current decreases at an increasing operation voltage. E.g., the reference current may initially increase with an increasing voltage, tend to decrease when the armature is moved from a valve seat to the core, and increase when the armature has reached the core. The reference current enables an effective comparison with the measured electric current.

Optionally, the reference current increases at a decreasing operation voltage. E.g., the reference current may initially decrease with a decreasing voltage, tend to increase when the armature is being released from the valve core, and decrease after the release from the valve core. The reference current enables an effective comparison with the measured electric current.

According to an aspect of the present invention, a computer program is provided. The computer program comprises instructions which, when the program is executed by a processor, causes the processor to carry out the method as described above. Optionally, the computer program comprises instructions to realize optional and/or preferred features and/or steps of the method as described above to achieve a technical effect corresponding thereto.

According to an aspect of the present invention, a solenoid valve for a vehicle, in particular utility vehicle, is provided. Therein, the valve comprises an armature being adapted to be moved by an application of an electromagnetic field to change a state of the valve, by moving the armature between two end positions, and an electronic control unit being adapted to perform the method as described above. Optionally, the electronic control unit is adapted to realize one or more optional features as described above with relation to the method to achieve a technical effect corresponding thereto.

Optionally, the electronic control unit is adapted to perform the method as described above as a diagnostic sequence. Therein, the above-described method steps may be repeatedly performed. In particular, cyclically adapting the operation voltage optionally comprises repeatedly and/or periodically adapting the operation voltage. In other words, different diagnostic pulses to diagnose the armature being transitioned between the first end position and the second end position, or vice versa, may be performed to increase the reliability of the estimation of the functioning.

According to an aspect of the present invention, a pneumatic brake arrangement for a vehicle, in particular utility vehicle, is provided. Therein, the pneumatic brake arrangement comprises the solenoid valve as described above. Therein, the solenoid valve of the pneumatic brake arrangement may comprise one or more optional features as described above to achieve a technical effect corresponding thereto.

In another embodiment, the solenoid valve may be used in any application, wherein the valve is controlled by an operating voltage with a directed current (DC). The operating voltage with a directed current enables the cyclic adaption of the operating voltage in a well-defined manner.

According to an aspect of the present invention, a vehicle, in particular utility vehicle, is provided. The vehicle, in particular utility vehicle, comprises the solenoid valve as described above and/or the pneumatic brake arrangement as described above. Therein, the solenoid valve and/or the pneumatic brake arrangement may comprise one or more optional features as described above to achieve a technical effect corresponding thereto.

An embodiment according to an aspect of the present disclosure is described with reference to the Figures below.
- Fig. 1: shows a schematic of a vehicle, in particular utility vehicle, according to an aspect of the disclosure;
- Fig. 2: shows a schematic flow chart of a method according to an aspect of the disclosure;
- Fig. 3: shows a schematic of an equivalent electric circuit of an electronic control unit of a valve according to an aspect of the disclosure;
- Fig. 4: shows a reference current and a representation of a dependence between an operating voltage on time, each of a valve according to an aspect of the disclosure; and
- Fig. 5: shows a reference current and a representation of a dependence between an operating voltage on time, each of a valve according to an aspect of the disclosure.

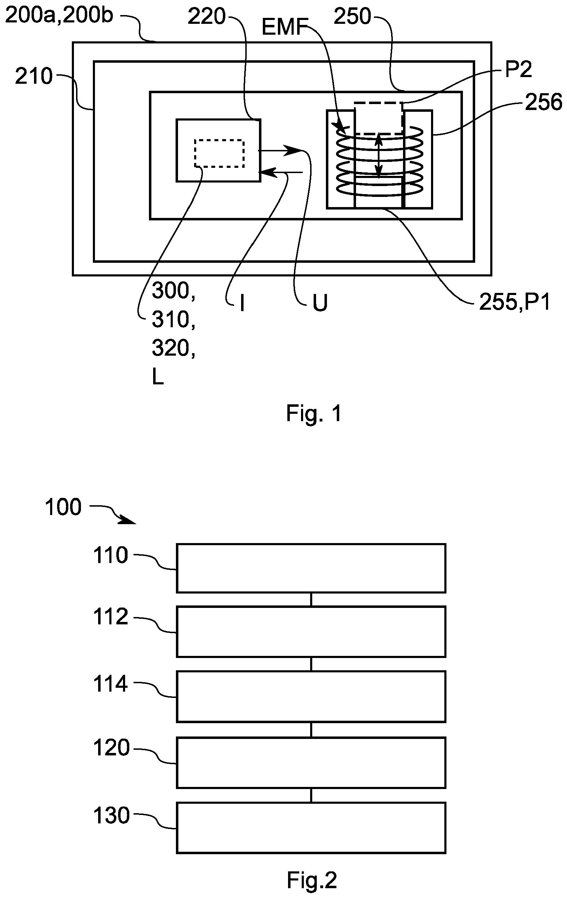

In the following embodiments are described with reference to Figures 1 to 5, wherein the same reference signs are used for the same objects throughout the description of the Figures and wherein the embodiment is just one specific example for implementing the disclosure and does not limit the scope of the disclosure as defined by the claims.

Figure 1 shows a schematic of a vehicle 200a, in particular utility vehicle 200b, according to an aspect of the disclosure. In the following, the vehicle 200a, in particular utility vehicle 200b, is referred to as vehicle 200a, 200b. The vehicle 200a, 200b is a land vehicle. The vehicle 200a, 200b may be a truck, a trailer and/or a bus.

The vehicle 200a, 200b comprises a pneumatic brake arrangement 210. The pneumatic brake arrangement 210 is adapted to achieve a deceleration of the vehicle 200a, 200b by applying a braking force and/or braking torque to one or more wheels (not shown) of the vehicle 200a, 200b. The pneumatic brake arrangement 210 comprises brakes (not shown) and is adapted to apply pressurized air to the brakes for applying the braking force and/or braking torque.

The pneumatic brake arrangement 210 comprises a solenoid valve 250. The valve 250 is adapted to control the application of the pressurized air. The valve 250 comprises an electronic control unit 220 to control the functioning of the valve 250 and the control of pressurized air by the valve 250. In another embodiment (not shown), the electronic control unit 220 may be comprised by the pneumatic brake arrangement 210 and the electronic control unit 220 and the valve 250 are electrically coupled with each other.

As shown in Figure 1, to control the pressurized air the valve 250 comprises an armature 255 being adapted to change a state of the valve 250, by moving the armature 255 between two end positions P1, P2. Therein, a first end position P1 may relate to the position of the armature 255 at a valve seat (not indicated). The armature 255 may be moved away from the first end position P1 against a spring force into a second end position P2. For example, the valve 250 is closed in the first end position P1, i.e., a supply port and a delivery port are fluidly and/or pneumatically disconnected, and the valve 250 is opened in the second end position P2, i.e., a supply port and a delivery port are fluidly and/or pneumatically interconnected.

The valve 250 is adapted to be operated and/or actuated by the application of an operation voltage U. The electronic control unit 220 is adapted to output the operation voltage U to the valve 250 to control the valve 250. The valve 250 comprises a core 256 to which operation voltage U is applicable. The operation voltage U causes an electric current I and an electromagnetic field EMF. The armature 255 is adapted to be moved by an application of the electromagnetic field EMF to change a state of the valve 250, by moving the armature 255 between the two end positions P1, P2.

The electronic control unit 220 is adapted to perform the method 100 as described with reference to Figure 2. Therein, the electronic control unit 220 is adapted to perform the method 100 as a diagnostic sequence.

Figure 2 shows a schematic flow chart of a method 100 according to an aspect of the disclosure. The method 100 of Figure 2 is a method 100 of estimating a functioning of a solenoid valve 250 for an open-loop pneumatic brake arrangement 210 for a vehicle 200a, in particular utility vehicle 200b, wherein the valve 250 comprises an armature 255 being adapted to be moved by an application of an electromagnetic field EMF to change a state of the valve 250 by moving the armature 255 between two end positions P1, P2. Such a vehicle 200a, 200b and valve 250 is described with reference to Figure 1. Figure 2 is described under reference to Figure 1.

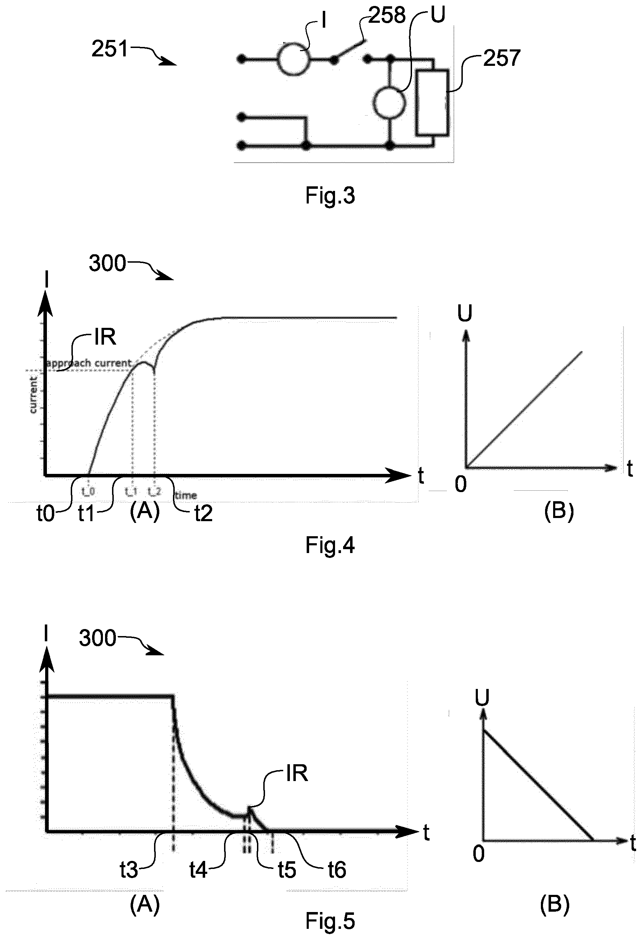

The method 100 of Figure 2 comprises: cyclically adapting 110 an operation voltage U for applying the electromagnetic field EMF. Therein, adapting 110 the operation voltage U comprises, dependent on time t, increasing 112 and decreasing 114 the operation voltage U. Therein, the operating voltage U may be increased 112 and decreased 114 once to achieve a cycle of the operation voltage U and/or a plurality of times to achieve a plurality of cycles, i.e., diagnostic pulses. Such an increase 112 of the operating voltage U is shown in Figure 4 (B) and a decrease 114 of the operating voltage U is shown in Figure 5 (B).

The method 100 of Figure 1 comprises: measuring 120, during adapting 110 the operation voltage U, an electric current I, depending on an inductivity L of the valve 250, on the operating voltage U and/or on time t. Performing measuring 120 the electric current I is further described with reference to Figure 3. Since the armature 255 may move due to the cyclically adapting 110 the operating voltage U, the electric current I is influenced by the operating voltage U and its time dependence. Therein, by moving the armature 255, the inductivity L of the valve 250 is influenced and varies accordingly. The inductivity L and the electric current I are interrelated. Thus, the inductivity L may be computed by measuring the electric current I.

The method 100 comprises: estimating 130, based on the electric current I, the functioning of the valve 250 indicating a proper arrangement of the armature 255 in one of the two end positions P1, P2. Estimating 130 the functioning of the valve 100 comprises comparing the electric current I with a reference current IR. The reference current IR comprises a non-monotonic time dependence 300 and/or voltage dependence 310. Therein, the reference current IR decreases at an increasing operation voltage U, and the reference current IR increases at a decreasing operation voltage U. Such reference currents IR are described further with reference to Figures 4 (A) and 5 (A), respectively.

The method 100 may be performed during a start-up of the vehicle 200a, 200b, or an system check of the pneumatic braking system 210. If the measured electric current I deviates from the reference current IR by more than a pre-defined threshold, a warning information may be issued. The warning information may be output into a memory for diagnostic purpose, by a output device which is perceivable by a driver and/or user of the vehicle 200a, 200b, and/or transmitted to an external server, e.g., a cloud being maintained and/or provided by a fleet provider. For example, the pre-defined threshold is 10 %.

Figure 3 shows a schematic of an equivalent electric circuit 251 of an electronic control unit 220 of a valve 250 according to an aspect of the disclosure. Such an electronic control unit 220 and a valve 250 is shown Figure 1. Figure 3 is described under reference to Figures 1 and 2.

The electric circuit 251 comprises a supply 257 which is adapted to supply the operation voltage U in a time-dependent manner. The electric circuit 251 is adapted to measure the operation voltage U which is supplied to the core 256 of the valve 250 and to measure the electric current I of the valve 250.

The electric circuit 251 comprises a switch 258 to control the valve.

Figure 4 shows a reference current IR and a representation of a dependence between an operating voltage U on time t, each of a valve 250 according to an aspect of the disclosure. Such a valve 250 is shown Figure 1. Figure 4 is described under reference to Figures 1 to 3. Figure 4 (A) shows a non-monotonic time dependence 300 of the reference current IR, i.e., the dependence of the reference current IR on time. Figure 4 (B) shows the dependence between voltage U and time t.

As illustrated in Figure 4 (B), the operation voltage U increases with time t. E.g. the operation voltage U is ramped up from 0 V with a rate of 0,2 V per second, e.g., to 24 V. At an operation voltage U of 0 V, the armature 255 may be positioned in the first end position P1, i.e., at the valve seat.

As illustrated in Figure 4 (A), the reference current IR is expected to change with time t due to the change of the operation voltage U as explained with reference to Figure 4 (B). As shown in Figure 4 (A), at an increasing operation voltage U and thus with time evolution, the electric current I is expected to increase from zero at a zeroth time t0. However, at a first time t1, the armature 255 starts moving away from the valve seat, i.e., from the first end position P1 towards the second end position P2, and the electric current I is expected to decrease between the first time t1 and a second time t2. When the armature 255 reaches the core 256 at the second time t2, the electric current I is expected to increase again. For estimating the functioning of the valve 250, in particular the electric current I at the first time t1, i.e., the so-called pull-in current when the armature 255 starts moving up from valve seat to the core 256 may be compared to the reference current IR. We are measuring the pressure level at 4th step upwards. The pull-in current and/or the corresponding reference current IR may be determined to compensate for pressure differences of up to 30 % due to temperature deviations.

Figure 5 shows a reference current IR and a representation of a dependence between an operating voltage U on time t, each of a valve 250 according to an aspect of the disclosure. Such a valve 250 is shown Figure 1. Figure 5 is described under reference to Figures 1 to 4.

As illustrated in Figure 5 (B), the operation voltage U decreases with time t. E.g. the operation voltage U is ramped down, e.g., from 24 V to 0 V with a rate of -0,2 V per second. At an operation voltage U of 0 V, the armature 255 may be positioned in the first end position P1, i.e., at the valve seat.

As illustrated in Figure 5 (A), the reference current IR is expected to change with time t due to the change of the operation voltage U as explained with reference to Figure 5 (B). As shown in Figure 5 (A), at a decreasing operation voltage U and thus with time evolution, the electric current I is expected to decrease between a third time t3 and a fourth time t4. However, at the fourth time t4, the armature 255 is released from the second end position P2 and starts moving towards the valve seat, i.e., from the second end position P2 towards to first end position P1, and the electric current I is expected to increase between the fourth time t4 and a fifth time t5. When the armature 255 is released from the core 256 at the fifth time t5, the electric current I is expected to decrease again until it reaches a sixth time t6 the first end position P1. For estimating the functioning of the valve 250, in particular the electric current I at the fourth time t4, i.e., when the armature 255 starts moving from core 256 towards the valve seat may be compared to the reference current IR.

The increasing 112 operating voltage U of Figure 4 (B) and the decreasing 114 operation voltage U of Figure 5 (B) constitute one cycle, i.e., one diagnostic pulse.

### Reference Signs (Part of the description)

- 100: method
- 110: adapting
- 112: increasing
- 114: decreasing
- 120: measuring
- 130: estimating

- 200a: vehicle
- 200b: utility vehicle
- 210: brake arrangement
- 220: electronic control unit
- 221: equivalent electric circuit
- 250: solenoid valve
- 255: armature
- 256: core
- 257: supply
- 258: switch

- 300: time-dependence
- 310: voltage-dependence
- 320: inductivity-dependence

- EMF: electromagnetic field
- P1: end position
- P2: end position
- U: operating voltage
- I: electric current
- IR: reference current
- L: inductivity
- t: time
- t0: zeroth reference time
- t1: first reference time
- t2: second reference time
- t3: third reference time
- t4: fourth reference time
- t5: fifth reference time
- t6: sixth reference time

## Claims

1. A method (100) of estimating a functioning of a solenoid valve (250) for an open-loop pneumatic brake arrangement (210) for a vehicle (200a), in particular utility vehicle (200b), wherein the valve (250) comprises an armature (255) being adapted to be moved by an application of an electromagnetic field (EMF) to change a state of the valve (250) by moving the armature (255) between two end positions (P1, P2), wherein the method (100) comprises the steps of:
- cyclically adapting (110) an operation voltage (U) for applying the electromagnetic field (EMF);
- measuring (120), during adapting (110) the operation voltage (U), an electric current (I), depending on an inductivity (L) of the valve (250), on the operating voltage (U) and/or on time (t); and
- estimating (130), based on the electric current (I), the functioning of the valve (250) indicating a proper arrangement of the armature (255) in one of the two end positions (P1, P2).

2. The method (100) as claimed in claim 1, wherein adapting (110) the operation voltage (U) comprises, dependent on time (t), increasing (112) and decreasing (114) the operation voltage (U).

3. The method (100) as claimed in claim 1 or 2, wherein estimating (130) the functioning of the valve (100) comprises comparing the electric current (I) with a reference current (IR).

4. The method (100) as claimed in claim 3, wherein the reference current (IR) comprises a non-monotonic time dependence (300) and/or voltage dependence (310).

5. The method (100) as claimed in claim 3 or 4, wherein the reference current (IR) decreases at an increasing operation voltage (U).

6. The method (100) as claimed in any one of claims 3 to 5, wherein the reference current (IR) increases at a decreasing operation voltage (U).

7. Computer program, comprising instructions which, when the program is executed by a processor, causes the processor to carry out the method (100) of any of claims 1 to 6.

8. Solenoid valve (250) for a vehicle (200a), in particular utility vehicle (200b),
wherein the valve (250) comprises an armature (255) being adapted to be moved by an application of an electromagnetic field (EMF) to change a state of the valve (250), by moving the armature (255) between two end positions (P1, P2), and an electronic control unit (220) being adapted to perform the method (100) as claimed in any one of claims 1 to 6.

9. Solenoid valve (250) as claimed in claim 8, wherein the electronic control unit (220) is adapted to perform the method as claimed in any one of claims 1 to 6 as a diagnostic sequence.

10. Pneumatic brake arrangement (210) for a vehicle (200a), in particular utility vehicle (200b), comprising the solenoid valve (250) as claimed in claim 8.

11. Vehicle (200a), in particular utility vehicle (200b), comprising the solenoid valve (250) as claimed in claim 8 or 9 and/or the pneumatic brake arrangement (210) as claimed in claim 10.
